(19) Europäisches Patentamt
European Patent Office
Office européen des brevets

(11) **EP 4 715 397 A1**

(12) **EUROPEAN PATENT APPLICATION**

(43) Date of publication:
**25.03.2026  Bulletin 2026/13**

(21) Application number: **25203758.5**

(22) Date of filing: **22.09.2025**

(51) International Patent Classification (IPC):
***G01R 15/06*** *(2006.01)*  ***G01R 15/16*** *(2006.01)*
***G01R 19/00*** *(2006.01)*

(52) Cooperative Patent Classification (CPC):
**G01R 15/16; G01R 15/06; G01R 19/0053**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **24.09.2024  US 202463698390 P**

(71) Applicant: **Analog Devices International
Unlimited Company
Co. Limerick (IE)**

(72) Inventors:
 • **Hurwitz, Jonathan Ephraim David
   Limerick (IE)**
 • **Brown, Christopher Thomas
   Limerick (IE)**

(74) Representative: **Horler, Philip John
   Withers & Rogers LLP
   2 London Bridge
   London SE1 9RA (GB)**

(54) **CAPACITIVE SENSING**

(57)    The present disclosure relates to capacitive sensing, for example for the purpose of non-contact voltage measurement. In the disclosure, an impedance that is dependent on the impedance of a capacitive sensing element is determinable by applying a known reference signal to a circuit comprising the capacitive sensing signal and measuring a resultant voltage. The resultant signal passes through a measurement circuit, such as one comprising a buffer and ADC, before being measured. The power supply of at least part of the measurement circuit is controlled in a predetermined way, for example based on the known reference signal.

**EP 4 715 397 A1**

## Description

## Technical Field

The present disclosure relates to capacitive signal sensing, such as non-contact voltage signal sensing.

## Background

Voltage measurement techniques often require a direct electrical connection to the current carrying conductor (i.e., a galvanic connection). However, in some situations this is not possible, or is inconvenient. For example, access for a galvanic connection may not be available, or the voltages may be very high (for example, in the 100s or 1000s of volts), requiring costly isolation between high and low voltage sides of the measurement circuit. In such circumstances, non-contact voltage measurement systems are useful. In a non-contact voltage measurement system, there is no direct electrical connection (i.e., no galvanic contact) between the conductor carrying the signal being sensed and the circuitry performing the measurement. Instead of a galvanic contact, a conductive sensing component may be positioned in non-contacting proximity to the conductor carrying the signal to be sensed (eg, positioned on, or near, an insulator that encases the conductor carrying the signal to be sensed), to form a capacitive coupling with the conductor carrying the signal to be sensed. Any changes in the signal being carried by the conductor should induce a signal in the conductive sensing component, as a result of the capacitive coupling, which can then be measured by circuitry connected to the conductive sensing component. Based on that, it is possible to measure the voltage of the current carrying conductor.

Such capacitive sensing techniques may also be useful for purposes other than voltage measurement, such as battery moisture detection.

## Summary

In a first aspect of the disclosure, there is provided a non-contact voltage measuring apparatus comprising: a sense plate for capacitively coupling with a conductor that is at a voltage which is to be measured; a measurement impedance coupled to the sense plate so as to form an impedance divider with the capacitive coupling of the sense plate to the conductor; and a measurement circuit having an input coupled to the impedance divider, wherein the apparatus is suitable for applying a reference signal that affects the voltage at the input of the buffer, and wherein the apparatus is configured to control a supply voltage to at least part of the measurement circuit based in part on the reference signal.

In a second aspect of the disclosure, there is provided a capacitive sensing apparatus comprising: a sensing capacitive component; a measurement circuit having an input coupled to the sensing capacitive component; and a reference signal generator arranged to generate a reference signal that affects a measurement signal at the input of the measurement circuit, wherein the apparatus is configured to control a supply voltage to at least part of the measurement circuit in a predetermined way.

In a third aspect of the disclosure, there is provided a method of determining an impedance value that is dependent on an impedance of a capacitive sense component, the method comprising: applying a reference signal to a sensing circuit that comprises the capacitive sense component; controlling, based in part on the reference signal, a supply voltage of at least part of a measurement circuit having an input that is coupled to the capacitive sense component; measuring, by the measurement circuit, a signal at the input of the measurement circuit; and determining the impedance value based on the reference signal and the measured signal.

## Drawings

Aspects of the present disclosure are described, by way of example only, with reference to the drawings, in which:

Figure 1 shows an example non-contact voltage measurement system;

Figures 2A and 2B show an example representation of a non-contact voltage measurement arrangement;

Figure 3 shows a measurement system similar to that of Figure 1, but includes a buffer;

Figures 4a to 4c show example schematic representations of the impedance divider of the system of

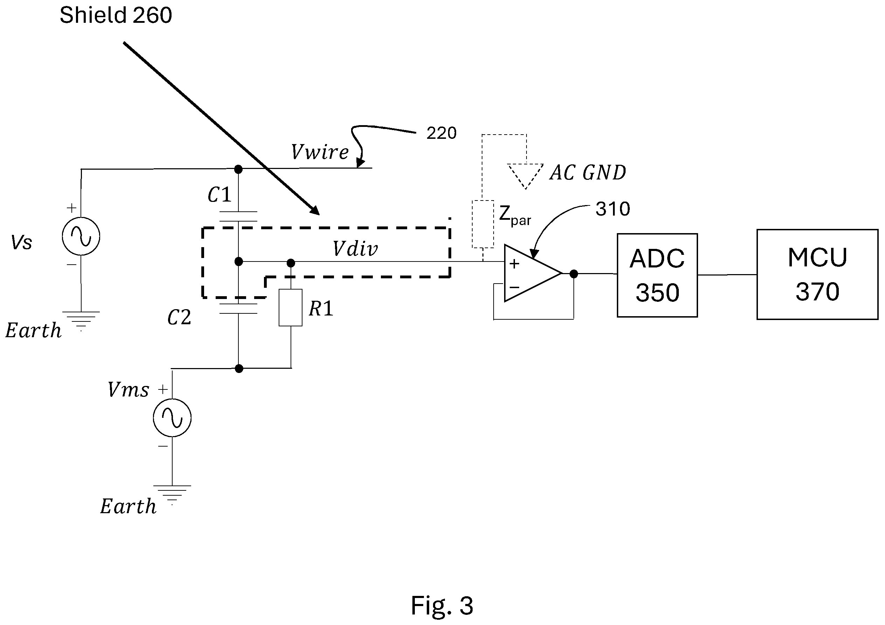

Figure 3, as experienced by different signals;

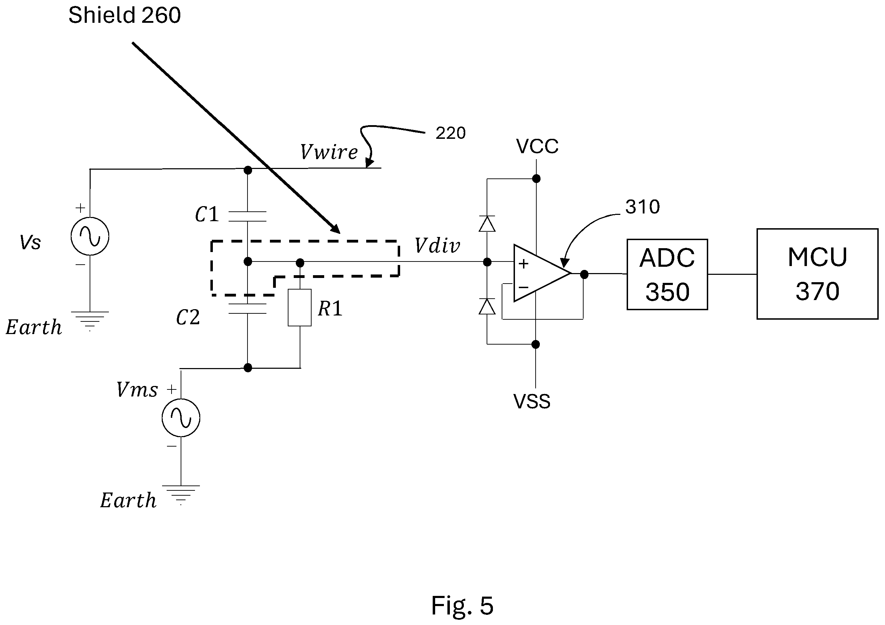

Figure 5 shows one example source of parasitic impedance in the system of Figure 3;

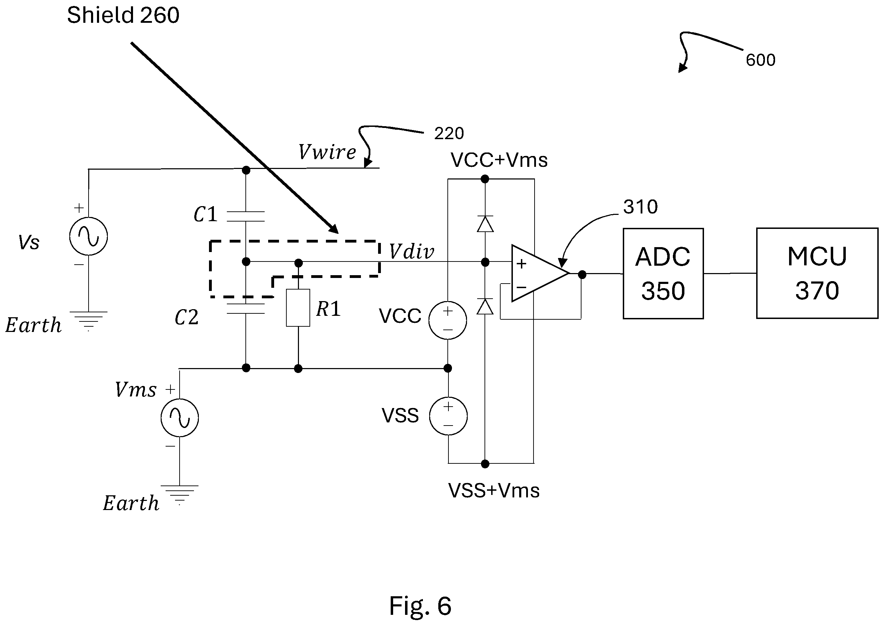

Figure 6 shows an example system in accordance with the present disclosure;

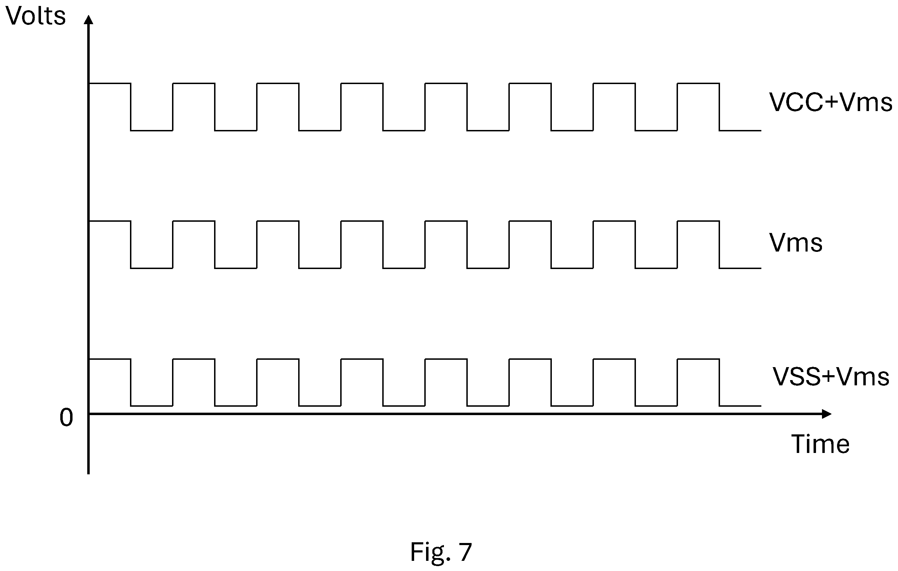

Figure 7 shows an example waveform representation of some of power supply related signals of the system of Figure 6;

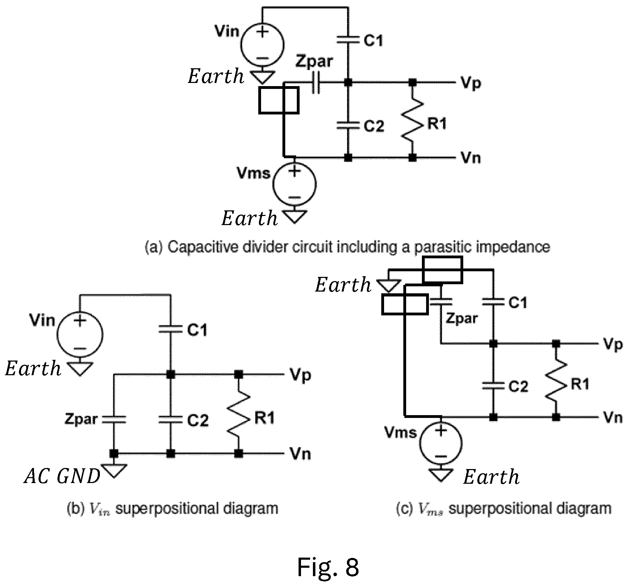

Figures 8a to 8c show example schematic representations of the impedance divider of the system of Figure 7, as experienced by different signals;

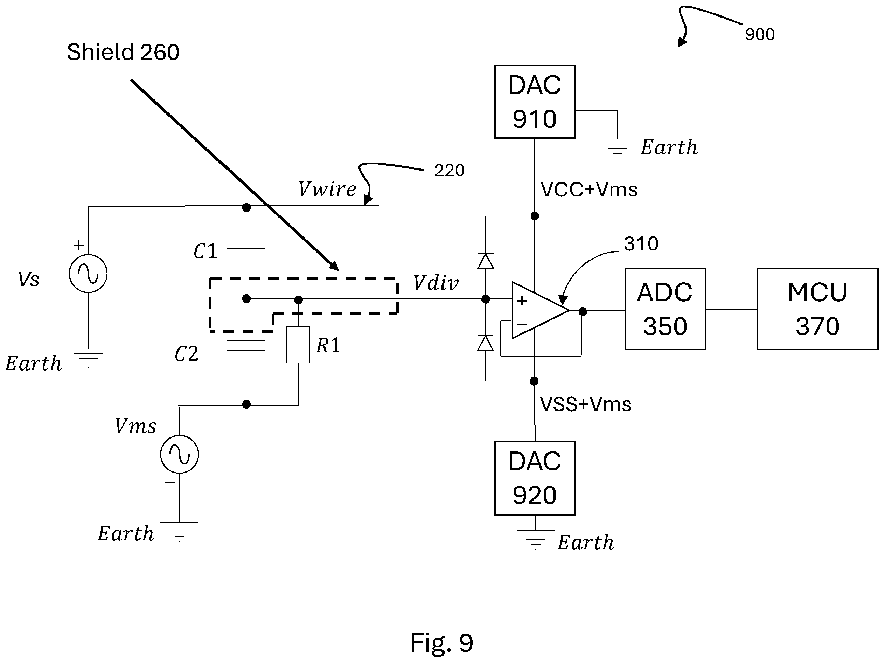

Figure 9 shows an example system in accordance with a further aspect of the present disclosure;

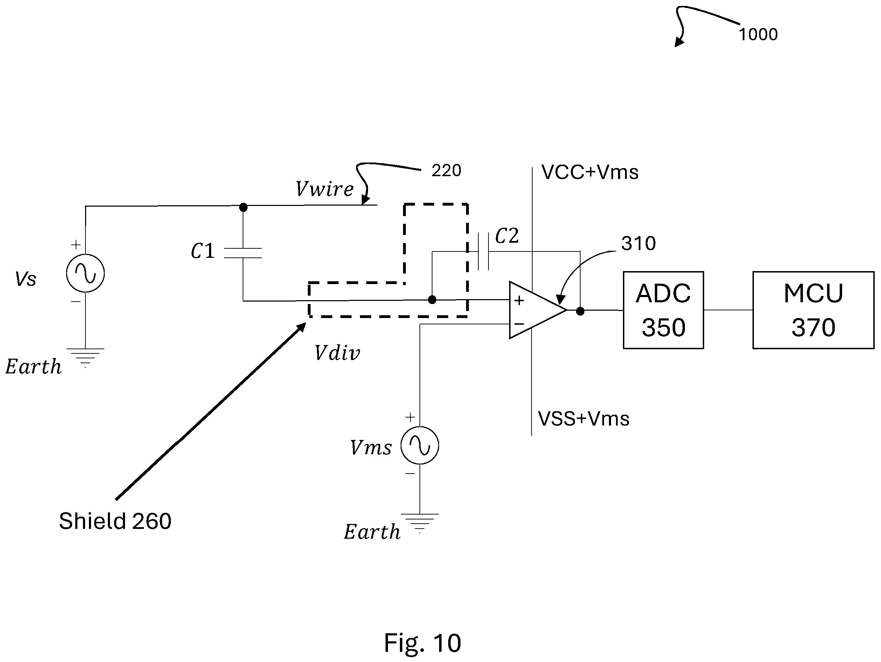

Figure 10 shows an example system in accordance with a further aspect of the present disclosure;

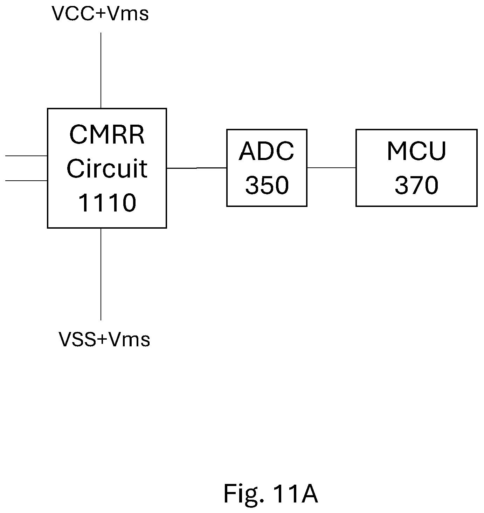

Figure 11A shows an example optional detail that can be used with the system of any of Figures 6, 9 and 10;

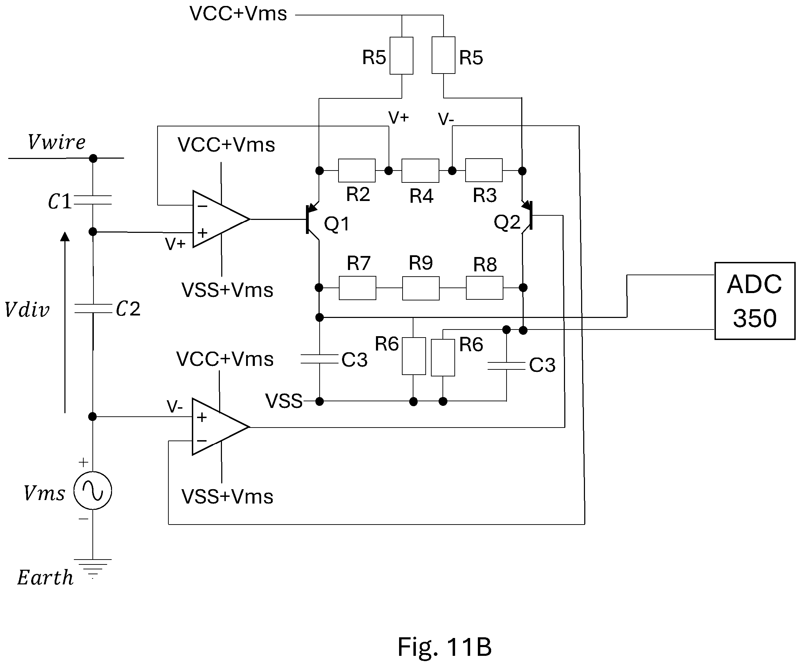

Figure 11B shows on example implementation of the buffer/gain stage of the detail of Figure 11A;

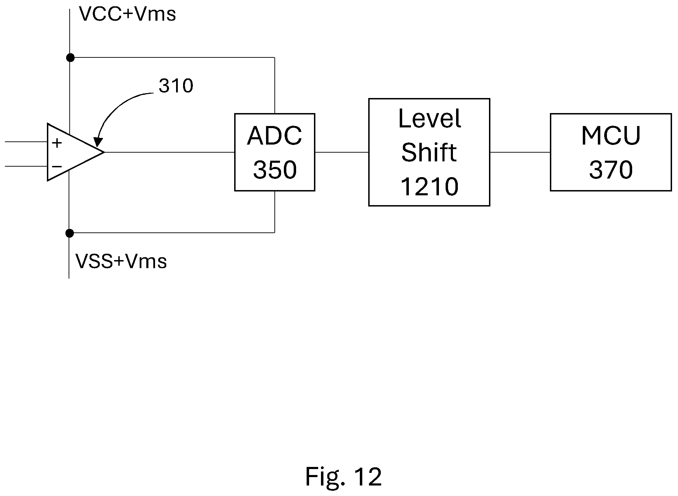

Figure 12 shows a further example optional detail that can be used with the system of any of Figures 6, 9 and 10;

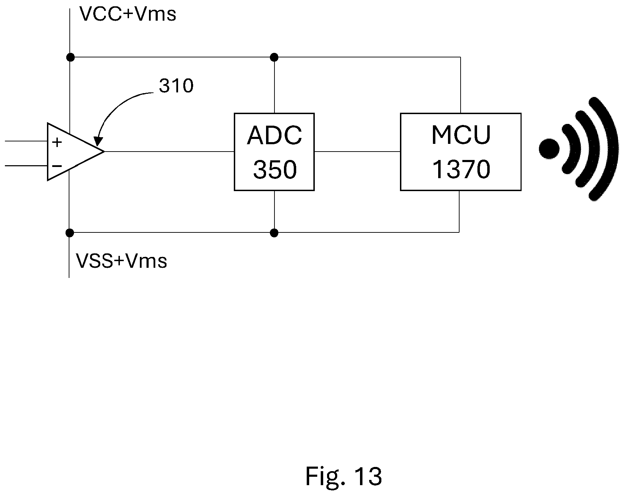

Figure 13 shows a further example optional detail that can be used with the system of any of Figures 6, 9 and 10; and

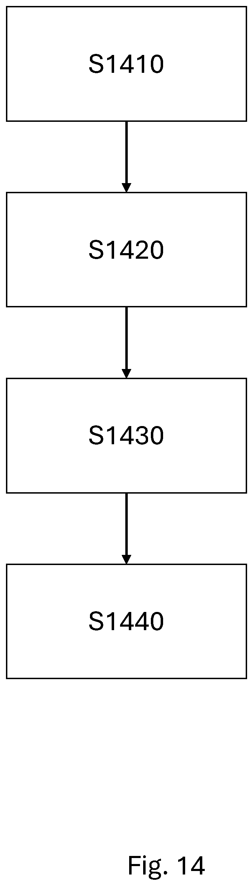

Figure 14 shows a representation of an example method in accordance with an aspect of the present disclosure.

## Detailed description

Capacitive sensing circuits, such as those used for non-contact voltage measurement and battery moisture detection, may utilise a reference signal, such as an alternating reference signal, to determine a relationship between the magnitude of the signal to be measured (such as the voltage to be measured) and the magnitude of the sensed signal. For example, the known reference signal may be applied to the sensing circuit and the resulting signal measured by a measurement circuit. The relationship (for example, the ratio) between the magnitude of the two signals may define the relationship between the magnitude of the signal to be measured and the magnitude of the sensed signal that is measured by the measurement circuit. From this, the signal to be measured may be measured by measuring the sensed signal and applying the determined relationship (eg, applying the determined ratio).

However, many measurement circuits have unwanted parasitic impedances at their input. Those parasitic impedances combine with the impedances of the sensing circuit in different ways for the known reference signal and the sensed signal. As a result, in practice, the sensing circuit signal input/output relationship that is determined using the known reference signal (eg, the determined ratio of the sensing circuit) may not actually be representative of the signal input/output relationship experienced by the sensed signal that is induced by the signal to be measured (eg, the voltage signal that is to be measured using the non-contact voltage techniques). This means that the sensing circuit relationship (eg, the signal input/output ratio) that is determined using the known reference signal may be different to the sensing circuit relationship (eg, the signal input/output ratio) experienced by the signal to be measured. This may reduce the accuracy of signal measurement.

The inventors have developed circuits whereby the power supply of the input component/device (for example, buffer or amplifier) to the measurement circuit is controlled based on the known reference signal. For example, the known reference signal may be superimposed on the normal power supply signals used for the input component/device. If the known reference signal is an oscillating signal, then the modified power supply will also oscillate. As a result, the potential difference across the parasitic impedances no longer moves with the known reference signal, since the potential on both sides of the parasitic impedances is moving by the same amount (i.e., they are both moving by the amount of the known reference signal). Consequently, the contribution of the parasitic impedance to the impedance of the sensing circuit is significantly reduced or eliminated, meaning that the sensing circuit relationship (eg, the signal input/output ratio) that is determined using the known reference signal should now be the same, or substantially the same, as the sensing circuit relationship (eg, the signal input/output ratio) experienced by the signal to be measured. The signal to be measured may therefore be more accurately measured based on the relationship determined using the known reference signal.

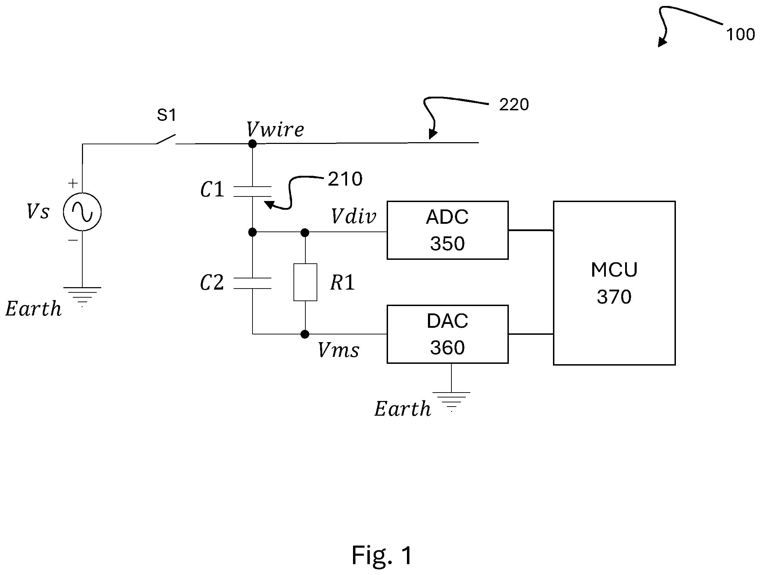

Figure 1 shows an example non-contact voltage measurement system 100. In this arrangement, a contactless sense plate 210 (which may also be referred to herein as one example of a capacitive sense component or a sensing capacitive component) is positioned in proximity (for example partially or fully surrounding) a circuit wire 220 in order to measure the voltage (Vwire) of the wire. The wire is coupled to an AC voltage source Vs and the circuit includes an optional circuit breaker S1. A parasitic capacitance C1 is formed between the wire 220 and the sense plate 210. The measurement circuit comprises an ADC 350 that is coupled to the sense plate 210 and is configured to measure the signal Vdiv.

To measure Vwire, particularly if it is larger than typical voltages of a measurement system, a voltage divider with C1 can be used. For this, another impedance (which may be referred to as a "measurement impedance" and is shown in Figure 1 as a capacitor C2) can be used to divide down Vwire so that a smaller voltage (Vdiv) can be measured in order to determine Vwire. Often, an impedance component is set such that its impedance is larger (or much larger) than the typical impedance of C1, so as to make Vdiv much smaller than Vwire. The system 100 of Figure 1 includes a resistor R1 in parallel with C2, which is arranged to provide a DC level as the system works with AC voltage signals and, without R1, Vdiv would be floating. The capacitor C2 and the resistor R1 may be collectively referred to as an impedance component Z1, as follows:

$$Z1 = \frac{1}{\frac{1}{C2} + \frac{1}{R1}}$$

Alternatively, if only resistor R1 is present, then Z1 = R1, and if only the capacitor C2 is present, then Z1 = C2.

As a result, Vdiv may be expressed as:

$$Vdiv = \frac{C1}{C1 + Z1} Vwire$$

The impedance divider circuit (i.e., the circuit formed by the contactless sense plate 210 and the impedance component Z1) may be referred to throughout this disclosure as a sensing circuit, since its function is to generate a sense signal Vdiv that is dependent on the signal Vwire to be measured.

Accurately measuring Vwire is dependent on knowledge of the divide ratio C1:Z1, and the value of at least one of C1 and Z1 may not be known accurately.

To address this, a known reference voltage Vms (which may also be referred to as a known perturbation voltage Vms) may be applied to the potential divider C1, Z1 (in this case, to the "bottom" of the potential divider) - i.e, applied to the sensing circuit. The known reference voltage Vms is a stimulating voltage having a known magnitude and may have a known frequency that is different to the frequency of Vwire, so that if both Vwire and Vms are applied to the potential divider at the same time, the effects that Vwire and Vms have on the measured signal Vdiv may be separated by the MCU 370. However, Vms may have any frequency, particularly if the system 100 is configured such at Vms is only applied to the potential divider when Vwire is not (for example, when Vs is turned off, or when S1 is open). In this example, Vms is generated to have a known, predetermined voltage magnitude by a digital to analog converter (DAC) 360, but it may alternatively be generated in any other suitable way (for example, by any type of circuit that can be controlled to output a known, predetermined voltage Vms, such as any type of voltage oscillator and/or reference circuit).

The system 100 may be configured to be operated at the same time as Vwire is present, in which case a signal caused by the Vms (referred to from here on as Vms') will appear simultaneously on Vdiv with a signal caused by Vwire (referred to from here on as Vwire'). A signal component in Vdiv that is caused by Vms (i.e., Vms') may be extracted from Vdiv (for example, extracted from the digital output of the ADC 350 by the MCU 370) if Vms (and therefore, by extension, Vms') has different characteristics to Vwire (and by extension, Vwire'), such as a different frequency and/or coding. In one particular example, Vms may be a slewrate limited square wave with a frequency chosen to be in between the harmonics of the fundamental frequency of Vwire. Vms may be a pseudo random sequence, an approximate sine wave or a chirp of frequencies, all of which have possible ways to be extracted from Vdiv with rejection of Vwire'.

The divided voltage Vdiv is measured by a measurement circuit, which in this example system comprises an analog to digital converter (ADC) 350. The output digital signal may be processed/used by any suitable analysis circuit/unit, such as a processor or in this example a microcontroller unit (MCU) 370. In this example system, the MCU 370 also controls the DAC 360, for example to control when the DAC 360 generates and outputs Vms, and optionally also to control a frequency and/or magnitude of Vms. In this arrangement, the MCU 370 is configured to extract Vms' and determine the impedance divider ratio using Vms and the extracted Vms' (for example, based on the magnitudes of Vms and Vms'). The MCU 370, or any other suitable analysis circuit/device, can also be configured to extract from the digital output of the ADC 350 the signal Vwire' and determine a measurement of the magnitude of Vwire from the extract Vwire' and the determined impedance divider ratio.

Whilst the term "MCU" is used throughout this disclosure, it should be appreciated that any suitable circuitry/processing means may be used to perform the described analysis functionality, for example dedicated circuitry, programable logic such as FPGAs, application specific integrated circuits (ASICs) and/or one or more processors such as one or more microprocessors arranged to executed software instructions to perform the described functionality.

When Vms is applied to the potential divider, Vdiv will include a voltage component Vms' that is caused by Vms. Therefore, Vms' may be determined from the ADC's digital measurement of Vdiv. If a voltage Vwire is also present on the wire then Vdiv will also include a voltage component Vwire' caused by Vwire. Vms' may be extracted from the digital measurement of Vdiv by the MCU 370, since the frequency of Vms is known and is different to Vwire. If, however, Vwire is not present on the wire at the time Vms is applied, then Vdiv may comprise only Vms', in which case Vms' is straightforwardly determined from the digital measurement of Vdiv.

The ratio of C1:Z1 may be found from the ratio of the magnitude of reference signal Vms to the measurement of Vms'. When the ratio of C1:Z1 is known, it can be used to determine Vwire from the measurement of Vwire'. Therefore, an accurate measurement of Vwire can be determined by measuring Vdiv and knowing Vms, even when one or both of C1 and Z1 are not known.

US patent application US2019/0081601 A1 (which is incorporated by reference in its entirety) explains this non-contact voltage measurement technique in more detail, particularly with reference to Figures 21 to 25.

This technique relies on the divider C1, Z1 "looking" the same in both directions (i.e., to signals applied to both the "top" and the "bottom" of the divider).

Figure 1 is merely one example implementation and many alternative system implementations are possible. For example, in Figure 1 the sensing circuit comprises a passive divider C1, Z1, but in an alternative an active divider may be used where C2 and R1 are around a buffer (for example, between an input and the output of an op amp buffer). Other approaches to divide Vwire to a signal Vdiv, and/or to provide a DC signal on Vdiv, are possible. It is also possible to use a resistor R2 instead of capacitor C2, in order to measure at the ADC a signal C1 $*dV_{div}/dt$, which may then be integrated to get to a measured signal C1*Vdiv/R2.

The measurement circuit often also comprises a buffer at the input to the ADC 350, such that Vdiv passes through the buffer before being input to the ADC 350. This sets a high impedance at the input to the measurement circuit and decreases the impedance before the ADC 350, as the capacitors C1 and C2, and the resistor R1, can be quite high impedance at the frequency of interest of Vwire (which is often around 50Hz or 60Hz - the typical frequencies of mains power). However, even with a high impedance buffer, parasitic impedances of the buffer can cause some difficulties in accurately measuring Vwire.

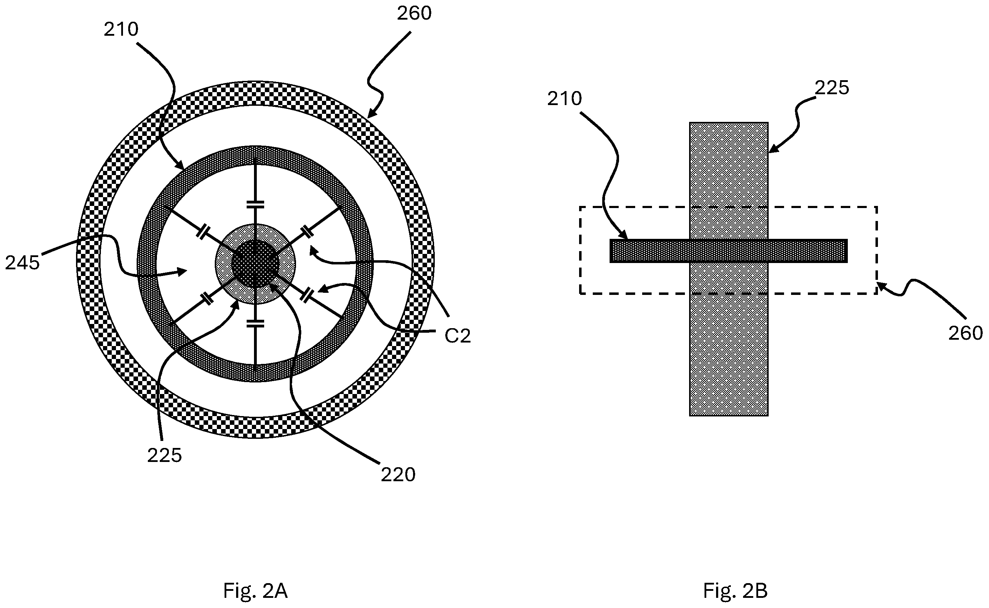

Figures 2A and 2B show an example representation of a non-contact voltage measurement arrangement. Figure 2A shows a top-down view. Figure 2B shows a side-on view. The arrangement includes a conductive sense component/plate 210 that surrounds an output circuit wire 220 (which is the wire have a potential Vwire). The parasitic capacitance C1 is formed between the output circuit wire 220 and the sense plate 210. In this example implementation, a conductive shield 260 also surrounds the sense plate 210 to help reduce the interference of external signals and impedances. In Figure 2B, only an outline of the conductive shield 260 is represented, so that the sense plate 210 is still visible.

Figures 2A and 2B show the conductive sense component 210 as a substantially circular ring, fully surrounding the conductor 220. This shape may have a benefit of causing the coupling capacitance between the conductive sense component 210 and the conductor 220 to be relatively constant regardless of the position of the conductor 220 within the circle. However, this is merely one example. In an alternative, the conductive sense component 210 may only partially surround the conductor 220, for example being a split ring, or may be of a completely different shape, such as a rectangular plate that is simply positioned in proximity to a part of the conductor 220. Alternatively, it could be a series of plates arranged around the conductor 220, or a planar structure like a ruff/collar. In some examples it could be part of the internal edge of a PCB(for example, plating the edge of the hole through which the conductor 220 passes, or formed as a series of conductive vias surrounding the hole through which the conductor 220 passes). Furthermore, regardless of the shape of the conductive sense component 210, it could be held in non-contacting proximity to the conductor 220 in any suitable way. Furthermore, any insulating material may be present between the conductive sense component 210 and the conductor 220, including (but not limited to) air and/or an insulating material coating the conductor 220. For example, the conductive sense component 210 may be configured to be attached directly to the outer surface of the insulator 225. Regardless, the non-contacting AC voltage sensing systems and methods described below are applicable to all designs and installations of conductive sense component 210, provided the conductive sense component 210 is suitable for positioning in non-contacting proximity to the conductor 220 so as to capacitively couple with the conductor 220.

Figure 3 shows a measurement system 300 that is similar to that represented in Figure 1, but that includes a buffer 310 in the measurement circuit, at the input to the measurement circuit. In this example representation, the source of Vms is represented differently to that of Figure 1, although it should be understood that the source of Vms may still be a DAC, or any other suitable circuit/unit. Whilst not shown in Figure 3, the system 300 may be configured for the MCU 370 to control the source of Vms, for example to control when Vms is and is not turned on, and/or to control the amplitude and/or frequency of Vms. Also represented is a simplified representation of the functional effect of the shield 260 of Figure 2. The shield 260 acts to shield from external interference at least part of the system 300, for example shielding from external interference at least some (or all) of C1, C2, R1 and/or the electrical connection between the impedance divider and the input to the measurement circuit.

Whilst the shield 260 helps to reduce interference and therefore unwanted parasitic impedances in the circuit, there can still be a parasitic impedance Zpar at the input to the buffer 310. Zpar may be a parasitic impedance to an "AC Ground". This may reduce the accuracy with which Vdiv can be measured, and therefore reduce the accuracy of Vwire measurement.

The term "AC Ground" (or "AC GND") in this disclosure is used to describe any signal/bias or supply that is not Vms or Vwire. It may be a static signal/bias, or a moving signal /bias that is different to Vms and Vwire i.e., unrelated/uncorrelated with Vms and Vwire, or correlated with Vms and Vwire, but scaled so the magnitudes are different.

The term "Earth" is used to describe a common reference for the Vs and Vms. The term "DC Ground" may also be used, but it should be clear that it is different to AC Ground, in that AC Ground is an unrelated, uncorrelated signal/reference that may have a fixed or moveable value compared with "Earth", Vms and Vwire.

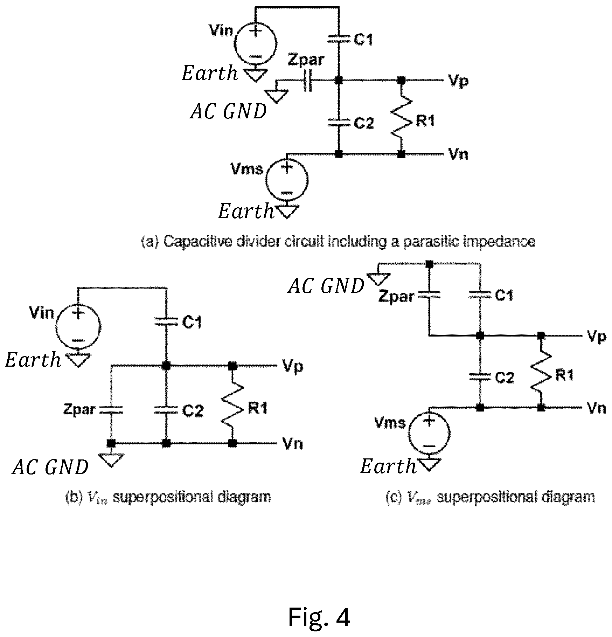

Figures 4a to 4c help to explain this further. In these examples, "Vin" is the same as "Vs" shown in Figures 1 and 3. Also the divided voltage is shown as Vp, which is the same as Vdiv in Figures 1 and 3. Also, in this example it is assumed that a differential voltage Vp-Vn would be measured by the ADC, although the circuit may alternatively be configured such as a single ended signal Vp is measured (as is the case in Figures 1 and 3).

The impedance Zpar is a parasitic impedance to AC Ground (i.e., any voltage signal/bias/supply that is not either Vin (Vs) or Vms). Each of Figures 4a, 4b and 4c show the effect of Zpar parasitic coupling to AC ground when different types of stimulation of the circuit (i.e., the stimulation of Vin and the stimulation of Vms). Because C2 is typically larger (and often much larger) than C1, the effect of Zpar on the accuracy of signal measurement can be significant.

Figure 4(a) shows the whole stimulated circuit and shows that Zpar is coupled to AC Ground. Figure 4(b) shows the equivalent circuit for the stimulation signal Vin (i.e., the circuit as "seen" by the Vin signal at its frequency, which is typically around 50 or 60Hz, for mains power measurement). In this equivalent circuit, Zpar is in parallel with C2.

Figure 4(c) shows the equivalent circuit for the stimulation signal Vms (i.e., the circuit as "seen" by the Vms signal at its frequency, which is different to that of Vin). In this equivalent circuit, Zpar is in parallel with C1.

This means that the impedance divider ratio (i.e. the ratio of C1:Z1) determined using Vms (i.e., by comparing Vms and Vms') actually defines the ratio of (C1+Zpar):Z1. However, the impedance divider ratio experienced by Vin is C1:(Z1+Zpar). Therefore, measurements of Vwire that are determined based on the measurement of Vdiv and the determined impedance divider ratio may be inaccurate (potentially by many %), since the signal Vin experiences a different impedance divider ratio to that which is determined using Vms. This may be particularly significant when C1 is much smaller than C2, for example when it is 100x smaller, or 1000x smaller, or 10000x smaller, etc which is often the case.

Figure 5 shows one example source of parasitic impedance Zpar at the input to the buffer 310. In this example, the buffer 310 includes input protection diodes that can introduce a parasitic impedance Zpar (for example, as a result of their depletion regions) at the input of the buffer 310 to the buffer supply voltages VCC and VSS (which act as AC Ground, since they are not Vwire or Vms). Whilst two input protection diodes are presented in Figure 5, in an alternative the buffer 310 may include only one input protection diode to either VCC or VSS.

There may be various other additional or alternative sources of parasitic impedance Zpar. For example, any MOS switching devices at the input to the buffer 310 may introduce parasitic gate-drain capacitance that capacitively couples the buffer input to an AC Ground. Additionally or alternatively any switches at the input, for example that are present for chopping and/or testing, may have a parasitic capacitance that capacitively couples the buffer 310 input to an AC Ground. There may also be various other passive or active components or devices at the buffer 310 input, or within the buffer 310, that may contribute to Zpar.

Regardless of the source(s) of Zpar at the input to the buffer 310, its effect on the accuracy of Vwire measurement is as described with reference to Figures 4(a) to (c).

Figure 6 shows an example representation of a solution to this problem. In this example system 600, the supply voltages to the buffer 310 are modulated, or set, based on the stimuli voltage Vms. In particular, the circuit is configured such that the two supply voltages to the buffer 310 are VCC+Vms and VSS+Vms. It will be appreciated from this that if Vms is applied to the sensing circuit only some of the time, for example at system startup or on demand, then the power supply of the buffer 310 is also only modulated using Vms at those same times.

Figure 7 shows an example waveform representation of the signals Vms, VCC+Vms and VSS+Vms. For example, if VCC is +5V, VSS is -5V and Vms oscillates between +5V and +6V, then VCC+Vms will oscillate between +10V and +11V and VSS+Vms will oscillate between 0V and +1V.

By moving VCC and VSS with Vms, both sides of Zpar (i.e., the side at the input to the buffer 310, which already moves with Vms in the arrangements of Figures 3 and 5, as well as the sides at VCC and VSS) move by similar amounts. Consequently, there is no extra current taken from C1, C2 and R1, and a Vms related signal from Zpar will not be superimposed. To put it another way, Zpar is still present in the circuit, but it reduces or removes its contribution since the potential difference across Zpar remains constant (or approximately constant). This technique should be effective at reducing or removing the effects of Zpar for any parasitic capacitances coupled to VCC or VSS, which is likely to be most, if not all, parasitic capacitances within the buffer 310 and active components in the circuit (which are likely to use VCC and/or VSS for power).

Figures 8(a) to (c) help to explain this effect further. They are the same as Figures 4(a) to (c) respectively, but show the effect of modulating AC Ground based on Vms. As can be seen, in all examples (i.e., from the perspective of both Vms and also Vin), Zpar is always in parallel with Z1, such that the divider ratio is the same for both stimulation signals (i.e., for both Vms and also Vin). As a result, when Vms is used to determine the divider ratio, that determined divider ratio is also experienced by Vin. Consequently, the accuracy of Vwire determination based on that determined divider ratio should be improved.

Whilst Figure 7 shows one example of how the buffer 310 supply voltages VCC and VSS may be modified, many other techniques may alternatively be used.

Figure 9 shows one example alternative system 900 where DACs 910 and 920 are used to set the supply voltage. The DACs 910 and 920 may be configured and controlled to set supply voltages VCC+Vms and VSS+Vms in any suitable way, for example by a sequenced controller that takes its timing from Vms, etc. Optionally, the system 900 may be configured so that the MCU 370 controls the DACs 910 and 920, for controlling the timing and amplitude of their analog outputs by setting suitable digital inputs to the DACs 910 and 920.

In the examples of Figures 6 to 9, the buffer 310 supply voltages are modulated to track Vms exactly. However, this is not essential and the buffer 310 supply voltages may be modulated by something other than Vms. For example, they may be modulated based in part on Vms, such as modulated by an amount that is dependent on Vms, but that is not exactly Vms (for example, the supply voltages may be modulated by a signal that is within +/- some % amount of Vms, such as a signal that is Vms +/- 5%, or Vms +/- 10%, or Vms +/- 20%, etc).

In a further alternative, the buffer 310 supply voltages may be modulated by an amount that is not linked to, or dependent on Vms, but that is entirely independent of Vms. For example, the supply voltage to the buffer 310 may be adjusted or modified in a predetermined way, which in some instances is based on Vms, and in other instances is independent of Vms. By modulating the supply voltages independently of Vms, the contribution of Zpar to the impedance ratio of the impedance divider may be determined, and may then subsequently be corrected for (for example, by digital correction by the MCU) so that an accurate determination of the impedance divider ratio experienced by Vwire may be determined.

Whilst the explanations above show both the positive and negative supply voltages of the buffer 310 being modulated, in an alternative only one of the two supply voltages may be modulated. Even if this does not eliminate the effects of Zpar entirely, it may still reduce the impact of Zpar and therefore improve the overall accuracy of Vwire determination. This may be particularly effective when Zpar is dominated by one of the supply voltages (for example because there is only one protection diode, which is coupled to that supply voltage) and that supply voltage is modulated.

In Figure 2, the sense plate 210 and the shield 260 are both shown to fully surround the wire 220. However, one or both of them may only partially enclose/encompass the wire 220 and provide imperfect operation, and the modulation technique for reducing the effect of Zpar should still be effective at improving Vwire measurement accuracy.

Whilst this disclosure focusses particularly on non-contact voltage measurement, the technique of modulating buffer 310 supply voltages may be used to improve the accuracy of other systems/circuits that use capacitive sensing. For example, various other sensing applications and circuits may require a determination of the impedance of at least one sensing capacitor (such as C1, or any other capacitor/capacitive element) in a sensing circuit (for example, the determination of an impedance divider ratio where the impedance divider includes at least one capacitor, or the determination of the capacitance of a single capacitor), where parasitic capacitances at the input of the measurement circuit may affect the accuracy of impedance determination. For these circuits, modulating at least one of the power supplies to the op amp / buffer may reduce the effect of the input parasitic capacitance and thereby improve the accuracy of the impedance sensing. One such example is moisture detection in batteries, which uses capacitive sensing. By reducing the effect of parasitic capacitances by modulating the buffer power supply, the capacitance may be more accurately sensed and battery moisture more reliably detected.

In the examples above, the buffer 310 does not have any gain (i.e., it has unity gain, such that the output signal of the buffer 310 should have the same magnitude as the input signal to the buffer 310). However, the techniques described above are also effective where the buffer310 has a non-unity gain (for example, where the buffer 310 is configured to act as an amplifier having a gain that is not unity - such as a gain that is greater or less than 1).

Figure 10 shows an alternative implementation, system 1000 where the capacitor C2 is arranged around the buffer 310 in a virtual earth configuration. Optionally, resistor R1 may also be present in the circuit in parallel with C2, for example to set the mid-node of the impedance divider (i.e., the inverting input to the buffer 310) to a desired DC level. In this example, as described above, at least one of the supply voltages VCC and VSS to the buffer 310 may be adjusted or modified, for example in dependence on Vms, in order to reduce the influence of Zpar.

In each of the systems of Figures 6, 9 and 10, the modulation signal Vms applied to the supply voltage of the buffer 310 will also appear at the output out of the buffer 310. Vms', which is the signal on Vdiv resulting from the application of Vms to the sensing circuit, either through direct application to the impedance divider or application to an input of the buffer 310 (as in Figure 10), is sometimes much smaller than Vms by virtue of the impedance divider ratio. For example, it may be about $1/1000^{th}$ of the magnitude of Vms. In this situation, the output of the buffer 310 at the signal frequency of Vms appears as a relatively large signal Vms superimposed with typically much smaller signal corresponding to Vms'. This can make it more difficult (for example, for the MCU 370) to extract Vms' from the signal output by the buffer 310, which is required in order to determine the ratio of the impedance divider. In some circumstances, for example when Vms' is not much smaller than Vms, then it may still be possible to extract Vms' without much difficulty. However, for implementations where Vms' is much smaller than Vms (for example, when it is $1/100^{th}$, or $1/1000^{th}$ of Vms), then it may be very difficult to extract Vms' accurately.

Figure 11A shows one example technique for resolving this difficulty. In Figure 11A, a buffer/gain stage 1110 (for example, amplifier circuit) with a high common mode rejection ratio (CMRR) 1110 is included in the measurement circuit. The buffer/gain stage 1110 is configured to reduce the common mode part of the signal that is converted by the ADC 350. Any suitable high CMRR circuit architecture that is well known to the skilled person may be used. If, for example, the buffer/gain stage 1110 has a CMRR of at least 120dB, the common-mode gain error may be reduced to 0.1% (60bB) or less, if the signal corresponding to Vms' in the output of the buffer 310 is 1/1000$^{th}$ of the magnitude of Vms.

Figure 11B shows on example implementation of the buffer/gain stage 1110. In this example, the matched pair of resistors R5 at the top of the circuit creates a DC common mode current to bias the transistors. The matched pair of resistors R6 at the bottom of the circuit (which may have the same resistance as R5) turn current back into a voltage and use the DC common mode current to move the DC level up from VSS. The current through resistors R2 and R3 (which are of equal resistance) is equal to (V+ - V-)/R4, owing to the virtual short the op-amp enforces at its inputs. The resistors R2, R3, R7 and R8 have the same value as each other, and R4 and R9 have the same value as each other, such that the differential voltage produced by the differential current has the same magnitude as the one produced across R2, R3 and R4. The transistors Q1 and Q2 may have a high current gain β., or be well matched in β so that only a minimal portion of the signal current flows in the base. If any base current does flow, it should not introduce a differential signal, thereby maintaining signal integrity. The circuit is configured to generate a DC common mode current, (V+ - V-)/R4, that is dependent on the input differential signal Vdiv, which is then converted back to a differential voltage by resistors R7, R8 and R9 in order to generate the differential output voltage. The common mode voltage in the circuit does not cause a current to flow, and is therefore rejected.

Optionally, one or more further buffer stages may be included between the output of the circuit shown in Figure 11B and the input to the ADC 350, which may be powered with an ummodulated power supply.

Whilst one particular implementation is shown in Figure 11B, the skilled person will understand that various alternative circuits may be used in order to achieve a relatively high CMRR.

Figure 12 shows a further example technique for resolving the difficulties caused by Vms modulation of the buffer 310 power supply. In this example, the ADC 350 uses the same modulated power supply as the buffer 310, and also the reference voltage used by the ADC 350 (not shown in the Figure for the sake of simplicity) is also modulated in the same way, based on Vms. By modulating the ADC 350 power supply (and the ADC reference voltage) in the same way as the buffer 310, the common mode problem is removed, since the ADC 350 is now moving in the same way as the common mode component on the signal output by the buffer 310. However, modulating the power supply of the ADC 350 with Vms causes the signal level of the digital output of the ADC 350 to move with Vms. To resolve this, a digital level shift circuit 1210 is coupled to the output of the ADC 350 in order to perform time dependent level shifting/conversion to shift the digital signal levels to correct the movement in the signal levels at the output of the AC 350. Consequently, the digital output of the digital level shift circuit 1210, which is received by the MCU 370, has substantially consistent signal levels. The digital level shift circuit 1210 may be implemented in any suitable way that will be well understood by the skilled person. The digital level shift circuit 1210 may require knowledge of the timing and magnitude of Vms, which it may obtain by being coupled to the Vms signal, or by any other means.

Figure 13 shows a further example technique for resolving the difficulties caused by Vms modulation of the buffer 310 power supply. This example assumes that the system is a closed system that is within its own isolated voltage domain. For example, it is not coupled to any other circuits/systems, and does not communicate with any circuits/systems, or communicates in a voltage domain isolated way, for example through wireless communications or communications through some other sort of isolation barrier. As such, Figure 13 shows an MCU 1310 that is functionally the same as MCU 310, but is configured for wireless communication with other systems/apparatus (for example, to wirelessly communicate the voltage or capacitance measurement).

In this example, the power supply for the MCU 1310 is the same as that for the buffer 310 and the ADC 350. Consequently, level shifting in the digital output of the ADC 350 is no longer a problem, because the MCU 1310 is also level shifting in exactly the same way so that there is no relative different in the signal levels at which the MCU 1310 and the ADC 350 operate.

If the technique of Figure 13 is used in a voltage measurement system, such as those of Figures 6, 9 and 10, and the measured voltage is used for power/energy measurement, then the corresponding current measurement channel should also use the same modulated power supply as the voltage measurement system. For example, any active circuitry, such as an amplifier(s) and/or ADC, in the current measurement channel should be powered by the modulated power supply used by the voltage measurement system. In this way, the digital current measurement signal will level shift in the same way as the digital voltage measurement signal, meaning that they can be used to determine an accurate energy/power measurement.

In an example where the system is implemented on a printed circuit board (PCB) and some components devices on the PCB have a modulated power supply (for example, modulated using Vms) and others do not, a four or more layer PCB may be used. In this way, some layers could be used for the modulated power supply and other layers could be used for the unmodulated power supply. In this way. Coupling between the two supply domains may be minimised. In some examples, the components/devices using the modulated power supply may be grouped together, and the components/devices not using the modulated power supply may be grouped separately. The layers used for the modulated power supply may be placed only beneath the components/devices using the modulated power supply, and the layers used for the non-modulated power supply may be placed only beneath the components/devices using the non-modulated power supply. This may help to even further minimise coupling between the two domains.

Figure 14 shows an example for determining an impedance value (such as the impedance divider ratio of the sensing circuit, or the capacitance of a capacitive sense component such as a non-contact sense plate or a moisture detection capacitance) that is dependent on an impedance of a capacitive sense component. In Step S1410, the reference signal Vms is applied to a sensing circuit that comprises the capacitive sense component. In Step S1420, the supply voltage of the buffer 310 is controlled in a predetermined way, for example based on Vms. In Step S1430, the resultant signal Vms' is measured at the buffer 310 output, for example by the ADC 350. In Step S1440, the impedance value is determined based on Vms and the measured resultant signal. In some use cases, such as battery moisture detection, determination of the impedance value may be the final goal, for example to determine whether or not there is a moisture problem. In other use cases, for example non-contact voltage measurement, a further step of voltage measurement may be performed based on the determined impedance value.

The skilled person will readily appreciate that various alterations or modifications may be made to the above described aspects of the disclosure without departing from the scope of the disclosure.

In most of the examples above, the input to the measurement circuit is formed by the buffer 310. However, in an alternative, the input may be formed by any other device/stage. For example, the buffer 310 may be omitted and the ADC 350 may be the input device to the measurement circuit. Regardless, in each example, at least the input device/stage (and optionally one or more further devices/stages) of the measurement circuit has its power supply modulated or controlled in a predetermined way, for example based on Vms. In this way, the negative effects of parasitic capacitance at the input of the measurement circuit may be reduced or eliminated.

In a further example, resistor R1 in each of the above examples is optional. Furthermore, in an alternative, rather than arranging resistor R1 as shown in Figures 3, 5, 6 and 9, the mid-node of the impedance divider (i.e., the node having voltage Vdiv) may be coupled to a known DC voltage by a high impedance path (for example, by resistor R1) in order to set the DC voltage of the mid-node to a desired level.

Optionally, the power supply modulated by Vms may also be used by one or more other signal processing circuits/units that are used to process the signal output by the buffer 310 (for example, the ADC). This may help to reduce the effects of any Zpar parasitics that may be present in those other signal processing circuits/units.

The terminology "coupled" used above encompasses both a direct electrical connection between two components, and an indirect electrical connection where the two components are electrically connected to each other via one or more intermediate components.

Each of the components/circuits/units/devices represented in each of the Figures may all be implemented in the same IC or chip package, or one or more of the components/circuits/units/devices may be implemented in a different IC or chip package and brought together to form the system. For example, the impedance component Z1 and the buffer 310 (and optionally the ADC 350) may all be part of a package, to which a power supply VSS/VCC, the reference voltage Vms and the MCU 370 may be coupled, for example via a plurality of pins.

## Aspects of the disclosure

Non-limiting aspects of the disclosure are set out in the following numbered clauses:

### First set of clauses

    1. A non-contact voltage measuring apparatus comprising:

        a sense plate for capacitively coupling with a conductor that is at a voltage which is to be measured;
        a measurement impedance coupled to the sense plate so as to form an impedance divider with the capacitive coupling of the sense plate to the conductor;
        a buffer having an input coupled to the impedance divider;
        a measurement circuit coupled to an output of the buffer and configured to measure an output voltage of the buffer; and
        a reference signal generator arranged to generate a reference signal (Vms) that affects the voltage at the input of the buffer;
        wherein the apparatus is configured to control a supply voltage to the buffer based in part on the reference signal.

    2. The apparatus of any preceding clause, wherein the measurement impedance is a capacitor or a resistor.

    3. The apparatus of any preceding clause, wherein the measurement impedance comprises a first terminal coupled to the sense plate.

    4. The apparatus of clause 3, wherein the input of the buffer is coupled to the first terminal of the measurement impedance.

    5. The apparatus of clause 3 or clause 4, wherein the measurement impedance comprises a second terminal.

6. The apparatus of clause 5, wherein the reference signal generator is coupled to the second terminal of the measurement impedance so as to apply the reference signal to the second terminal of the measurement impedance.

7. The apparatus of any of clauses 1 to 5, wherein the buffer comprises an op amp having two input terminals, wherein a first input terminal is coupled to the impedance divider and the reference signal generator is coupled to a second input terminal.

8. The apparatus of clause 7, wherein the op amp is configured in a virtual earth arrangement such that the reference signal applied to the second input terminal causes a corresponding change in the signal at the first input terminal.

9. The apparatus of any preceding clause, wherein the buffer has unity gain or non-unity gain.

10. The apparatus of any preceding clause, wherein a single supply voltage to the buffer is controlled based in part on the reference signal, or two supply voltages to the buffer are controlled based in part on the reference signal.

11. The apparatus of any preceding clause, wherein the supply voltage to the buffer is controlled to be set to a sum or difference of a predetermined voltage signal (VSS or VCC) and the reference signal, or to a sum or difference of a predetermined voltage signal (VSS or VCC) and a voltage that is derived from, or correlated with, the reference signal.

12. The apparatus of any preceding clause, wherein the measurement impedance is coupled between the input of the buffer and the output of the buffer.

13. A capacitive sensing apparatus comprising:

a sensing capacitive component for sensing a signal to be measured;
a buffer having an input coupled to the sensing capacitive component; and
a reference signal generator arranged to generate a reference signal that affects a measurement signal at the input of the buffer;
wherein the apparatus is configured to adjust or modify a supply voltage to the buffer in a predetermined way.

14. The apparatus of clause 13, further comprising a measurement circuit coupled to an output of the buffer and configured to measure an output voltage of the buffer, wherein the measurement of the output voltage of the buffer is for use in determining a measurement of the signal to be measured.

15. The apparatus of clause 13 or clause 14, wherein the predetermined way in which the supply voltage is adjusted or modified is dependent on the reference signal.

16. The apparatus of any of clauses 13 to 15, wherein an impedance value that is dependent on the impedance of the sensing capacitive element is determinable based on the reference signal and a measurement of a signal at an output of the buffer, and wherein the signal to be measured is measurable using the impedance value and the measurement of the signal at the output of the buffer.

17. **The** apparatus of clause 16, further comprising:

a measurement impedance coupled to the sensing capacitive component so as to form an impedance divider with the sensing capacitive component,
wherein the impedance value is dependent on a ratio of an impedance of the sensing capacitive component and the measurement impedance.

18. **The** apparatus of clause 17, wherein the measurement impedance is a capacitor or a resistor.

19. **The** apparatus of any preceding clause, wherein the sensing capacitive component comprises a probe or plate for capacitively coupling to a conductor.

Second set of clauses

1. A non-contact voltage measuring apparatus comprising:

a sense plate for capacitively coupling with a conductor that is at a voltage which is to be measured;
a measurement impedance coupled to the sense plate so as to form an impedance divider with the capacitive coupling of the sense plate to the conductor; and
a measurement circuit having an input coupled to the impedance divider,
wherein the apparatus is suitable for applying a reference signal that affects the voltage at the input of the buffer, and
wherein the apparatus is configured to control a supply voltage to at least part of the measurement circuit based in part on the reference signal.

2. The non-contact voltage measuring apparatus of clause 1, wherein the measurement circuit comprises a buffer and the apparatus is configured to control the supply voltage to the buffer based in part on the reference signal.

3. The apparatus of any preceding clause, further comprising:
a reference signal generator arranged to generate the reference signal.

3. The apparatus of any preceding clause, wherein the measurement impedance comprises a first terminal coupled to the sense plate.

4. The apparatus of clause 3, wherein the input of the measurement circuit is coupled to the first terminal of the measurement impedance.

5. The apparatus of clause 3 or clause 4, wherein the measurement impedance comprises a second terminal.

6. The apparatus of clause 5, wherein the apparatus is configured for the reference signal to be applied to the second terminal of the measurement impedance.

7. The apparatus of any of clauses 1 to 5, wherein the measurement circuit comprises an op amp having two input terminals, and

> wherein a first input terminal of the op amp is coupled to the impedance divider, and
> wherein the apparatus is configured for the reference signal to be applied to a second input terminal of the op amp.

8. The apparatus of clause 7, wherein the op amp is configured in a virtual earth arrangement such that the reference signal applied to the second input terminal causes a corresponding change in the signal at the first input terminal.

9. The apparatus of any preceding clause, wherein a single supply voltage to the buffer is controlled based in part on the reference signal, or two supply voltages to the buffer are controlled based in part on the reference signal.

10. The apparatus of any preceding clause, wherein the supply voltage to the buffer is controlled to be set to a sum or difference of a predetermined voltage signal and the reference signal.

11. The apparatus of any of clauses 1 to 9, wherein the supply voltage to the buffer is controlled to be set to a sum or difference of a predetermined voltage signal and a voltage that is derived from, or correlated with, the reference signal.

12. The apparatus of any preceding clause, wherein the measurement impedance is coupled between the input of the buffer and the output of the buffer.

13. A capacitive sensing apparatus comprising:

> a sensing capacitive component;
> a measurement circuit having an input coupled to the sensing capacitive component; and
> a reference signal generator arranged to generate a reference signal that affects a measurement signal at the input of the measurement circuit,
> wherein the apparatus is configured to control a supply voltage to at least part of the measurement circuit in a predetermined way.

14. The apparatus of clause 13, wherein the measurement circuit comprises a buffer and the apparatus is configured to control the supply voltage to at least the buffer in the predetermined way.

15. The apparatus of clause 13 or clause 14, wherein the predetermined way in which the supply voltage is controlled is dependent on the reference signal.

16. The apparatus of any of clauses 13 to 15, wherein an impedance value that is dependent on the impedance of the sensing capacitive element is determinable based on the reference signal and a measurement of a signal at an output of the buffer.

17. The apparatus of clause 16, further comprising:

> a measurement impedance coupled to the sensing capacitive component so as to form an impedance divider with the sensing capacitive component,
> wherein the impedance value is dependent on a ratio of the impedance divider.

18. The apparatus of clause 17, wherein the measurement impedance comprises at least one of: a capacitor; and a resistor.

19. The apparatus of any of clauses 13 to 18, wherein the sensing capacitive component comprises a probe or plate for capacitively coupling to a conductor.

20. A method of determining an impedance value that is dependent on an impedance of a capacitive sense component, the method comprising:

> applying a reference signal to a sensing circuit that comprises the capacitive sense component;
> controlling, based in part on the reference signal, a supply voltage of at least part of a measurement circuit having an input that is coupled to the capacitive sense component;
> measuring, by the measurement circuit, a signal at the input of the measurement circuit; and
> determining the impedance value based on the reference signal and the measured signal.

21. The method of clause 20, wherein controlling the supply voltage of at least part of the measurement circuit comprises controlling the supply voltage to be a sum or difference of a predetermined voltage signal and a voltage that is derived from, or correlated with, the reference signal.

22. The method of clause 20 or clause 21, wherein the measurement circuit comprises a buffer having an input that is coupled to the capacitive sense component, and wherein controlling the supply voltage of at least part of the measurement circuit comprises controlling the supply voltage of the buffer.

23. The method of any of clauses 20 to 22, wherein the measurement circuit comprises an analog to digital converter, ADC, and wherein controlling the supply voltage of at least part of the measurement circuit comprises controlling the supply voltage of the ADC.

## Claims

1. A non-contact voltage measuring apparatus comprising:

   a sense plate for capacitively coupling with a conductor that is at a voltage which is to be measured;
   a measurement impedance coupled to the sense plate so as to form an impedance divider with the capacitive coupling of the sense plate to the conductor; and
   a measurement circuit having an input coupled to the impedance divider,
   wherein the apparatus is suitable for applying a reference signal that affects the voltage at the input of the buffer, and
   wherein the apparatus is configured to control a supply voltage to at least part of the measurement circuit based in part on the reference signal.

2. The non-contact voltage measuring apparatus of claim 1, wherein the measurement circuit comprises a buffer and the apparatus is configured to control the supply voltage to the buffer based in part on the reference signal.

3. The apparatus of any preceding claim, further comprising:
   a reference signal generator arranged to generate the reference signal.
   3. The apparatus of any preceding claim, wherein the measurement impedance comprises a first terminal coupled to the sense plate.

4. The apparatus of claim 3, wherein the input of the measurement circuit is coupled to the first terminal of the measurement impedance.

5. The apparatus of claim 3 or claim 4, wherein the measurement impedance comprises a second terminal.

6. The apparatus of claim 5, wherein the apparatus is configured for the reference signal to be applied to the second terminal of the measurement impedance.

7. The apparatus of any of claims 1 to 5, wherein the measurement circuit comprises an op amp having two input terminals, and

   wherein a first input terminal of the op amp is coupled to the impedance divider, and

wherein the apparatus is configured for the reference signal to be applied to a second input terminal of the op amp.

8. The apparatus of claim 7, wherein the op amp is configured in a virtual earth arrangement such that the reference signal applied to the second input terminal causes a corresponding change in the signal at the first input terminal.

9. The apparatus of any preceding claim, wherein a single supply voltage to the buffer is controlled based in part on the reference signal, or two supply voltages to the buffer are controlled based in part on the reference signal.

10. The apparatus of any preceding claim, wherein the supply voltage to the buffer is controlled to be set to a sum or difference of a predetermined voltage signal and the reference signal.

11. The apparatus of any of claims 1 to 9, wherein the supply voltage to the buffer is controlled to be set to a sum or difference of a predetermined voltage signal and a voltage that is derived from, or correlated with, the reference signal.

12. The apparatus of any preceding claim, wherein the measurement impedance is coupled between the input of the buffer and the output of the buffer.

13. A method of determining an impedance value that is dependent on an impedance of a capacitive sense component, the method comprising:

   applying a reference signal to a sensing circuit that comprises the capacitive sense component;
   controlling, based in part on the reference signal, a supply voltage of at least part of a measurement circuit having an input that is coupled to the capacitive sense component;
   measuring, by the measurement circuit, a signal at the input of the measurement circuit; and
   determining the impedance value based on the reference signal and the measured signal.

14. The method of claim 13, wherein controlling the supply voltage of at least part of the measurement circuit comprises controlling the supply voltage to be a sum or difference of a predetermined voltage signal and a voltage that is derived from, or correlated with, the reference signal.

15. The method of claim 13 or claim 14, wherein the measurement circuit comprises a buffer having an input that is coupled to the capacitive sense component, and

wherein controlling the supply voltage of at least part of the measurement circuit comprises controlling the supply voltage of the buffer.

Fig. 1

EP 4 715 397 A1

Fig. 2A

Fig. 2B

Fig. 3

EP 4 715 397 A1

(a) Capacitive divider circuit including a parasitic impedance

(b) $V_{in}$ superpositional diagram

(c) $V_{ms}$ superpositional diagram

Fig. 4

EP 4 715 397 A1

Fig. 5

Fig. 6

Fig. 7

EP 4 715 397 A1

(a) Capacitive divider circuit including a parasitic impedance

(b) $V_{in}$ superpositional diagram

(c) $V_{ms}$ superpositional diagram

Fig. 8

Fig. 9

EP 4 715 397 A1

1000

VCC+Vms

310

C2

220

Vwire

C1

Vs

Earth

Vdiv

Shield 260

Vms

Earth

VSS+Vms

ADC 350

MCU 370

Fig. 10

Fig. 11A

Fig. 11B

VCC+Vms

310

ADC
350

Level
Shift
1210

MCU
370

VSS+Vms

Fig. 12

VCC+Vms

310

ADC
350

MCU
1370

VSS+Vms

Fig. 13

EP 4 715 397 A1

```
┌─────────────────────┐
│                     │
│       S1410         │
│                     │
└─────────────────────┘
           │
           ▼
┌─────────────────────┐
│                     │
│       S1420         │
│                     │
└─────────────────────┘
           │
           ▼
┌─────────────────────┐
│                     │
│       S1430         │
│                     │
└─────────────────────┘
           │
           ▼
┌─────────────────────┐
│                     │
│       S1440         │
│                     │
└─────────────────────┘
```

Fig. 14

Europäisches
Patentamt

European
Patent Office

Office européen
des brevets

# EUROPEAN SEARCH REPORT

Application Number

EP 25 20 3758

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2019/081601 A1 (HURWITZ JONATHAN EPHRAIM DAVID [GB] ET AL) 14 March 2019 (2019-03-14) * paragraphs [0009], [0014] - [0017], [0085] - [0098], [0109], [0118]; figures 7, 11, 12, 21, 22, 24 * | 1-15 | INV. G01R15/06 G01R15/16 G01R19/00 |
| A | US 2010/283539 A1 (YANAGISAWA KOICHI [JP]) 11 November 2010 (2010-11-11) * the whole document * | 1-15 | |
| A | US 2014/021965 A1 (DE RYBEL TOM [BE] ET AL) 23 January 2014 (2014-01-23) * the whole document * | 1-15 | |

TECHNICAL FIELDS
SEARCHED     (IPC)

G01R

The present search report has been drawn up for all claims

| Place of search | Date of completion of the search | Examiner |
|---|---|---|
| Munich | 8 February 2026 | Jedlicska, István |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

    ............................................................................................

& : member of the same patent family, corresponding
document

EPO FORM 1503 03.82 (P4C01)

## ANNEX TO THE EUROPEAN SEARCH REPORT
## ON EUROPEAN PATENT APPLICATION NO.

EP 25 20 3758

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2026

| Patent document cited in search report | | | Publication date | Patent family member(s) | | | Publication date |
|---|---|---|---|---|---|---|---|
| US 2019081601 | A1 | | 14-03-2019 | CN | 109470904 | A | 15-03-2019 |
| | | | | CN | 113495179 | A | 12-10-2021 |
| | | | | CN | 113504403 | A | 15-10-2021 |
| | | | | EP | 3679653 | A1 | 15-07-2020 |
| | | | | EP | 4446754 | A2 | 16-10-2024 |
| | | | | US | 2019081601 | A1 | 14-03-2019 |
| | | | | WO | 2019048579 | A1 | 14-03-2019 |
| US 2010283539 | A1 | | 11-11-2010 | CN | 101881791 | A | 10-11-2010 |
| | | | | US | 2010283539 | A1 | 11-11-2010 |
| US 2014021965 | A1 | | 23-01-2014 | AU | 2012234320 | A1 | 17-10-2013 |
| | | | | BR | 112013024503 | A2 | 08-08-2017 |
| | | | | CN | 103718049 | A | 09-04-2014 |
| | | | | EP | 2689256 | A1 | 29-01-2014 |
| | | | | JP | 6050309 | B2 | 21-12-2016 |
| | | | | JP | 2014508951 | A | 10-04-2014 |
| | | | | MY | 170790 | A | 28-08-2019 |
| | | | | US | 2014021965 | A1 | 23-01-2014 |
| | | | | WO | 2012130816 | A1 | 04-10-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 20190081601 A1